(19)

**Europäisches Patentamt**
**European Patent Office**
**Office européen des brevets**

(11) **EP 4 664 135 A2**

(12) **EUROPEAN PATENT APPLICATION**

(43) Date of publication:
**17.12.2025 Bulletin 2025/51**

(21) Application number: **25181978.5**

(22) Date of filing: **11.06.2025**

(51) International Patent Classification (IPC):
**G01R 33/00** (2006.01)    **G01R 33/09** (2006.01)

(52) Cooperative Patent Classification (CPC):
**G01R 33/0011; G01R 33/0017; G01R 33/0035;**
**G01R 33/09**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **11.06.2024 JP 2024094155**

(71) Applicants:
• **TDK Corporation**
**Tokyo 103-6128 (JP)**

• **Kanazawa Institute of Technology**
**Ishikawa 921-8501 (JP)**

(72) Inventors:
• **SHIBUYA, Tomohiko**
**Tokyo, 103-6128 (JP)**
• **ADACHI, Yoshiaki**
**Ishikawa, 921-8501 (JP)**

(74) Representative: **Epping - Hermann - Fischer**
**Patentanwaltsgesellschaft mbH**
**Schloßschmidstraße 5**
**80639 München (DE)**

(54) **MAGNETIC SENSOR AND SENSITIVITY MEASUREMENT METHOD THEREOF**

(57)    Disclosed herein is a sensitivity measurement method for measuring a sensitivity of a magnetic sensor provided with a sensor chip having a magnetosensitive element, a magnetism collecting body for collecting a magnetic field to the sensor chip, and a housing for accommodating therein the sensor chip and the magnetism collecting body. The method includes applying a magnetic field to the magnetic sensor, and calculating the sensitivity of the magnetic sensor based on a simple average value of theoretical magnetic field strengths at a plurality of virtual sensitivity points evenly distributed inside the housing and an output value output from the senor chip.

FIG. 10

**Description**

BACKGROUND OF THE ART

--Field of the Art

The present disclosure relates to a magnetic sensor, a sensitivity measurement method thereof, and a magnetic field detection device.

--Description of Related Art

Adachi, Y. et al., Evaluation of Directional Dependence of Sensitivity for Room-Temperature Magnetic Flux Sensors with Wide Sensitivity Region, IEEE transactions on Magnetics, 57 (2), 4000105, 2021 (hereinafter referred to as Non-Patent Document 1) discloses a method of measuring the sensitivity of a magnetic sensor including an MR element.

However, in the sensitivity measurement method described in the above Non-Patent Document, weighting parameters called relative sensitivity are added to a plurality of respective sensitivity points, so that calculation becomes complicated and, in some cases, may fail to converge.

SUMMARY

The present disclosure relates to a sensitivity measurement method of a magnetic sensor and describes a technology for reducing calculation amount in the method while maintaining measurement sensitivity.

A sensitivity measurement method according to an aspect of the present disclosure is a method for measuring the sensitivity of a magnetic sensor provided with a sensor chip having a magnetosensitive element, a magnetism collecting body for collecting a magnetic field to the sensor chip, and a housing for accommodating therein the sensor chip and the magnetism collecting body. The method includes applying a magnetic field to the magnetic sensor and calculating the sensitivity of the magnetic sensor based on a simple average value of theoretical magnetic field strengths at a plurality of virtual sensitivity points evenly distributed inside the housing and an output value output from the senor chip.

According to the present disclosure, a technology for reducing a calculation amount in the sensitivity measurement method of a magnetic sensor while maintaining measurement sensitivity.

BRIEF DESCRIPTION OF THE DRAWINGS

The above features and advantages of the present disclosure will be more apparent from the following description of some embodiments taken in conjunction with the accompanying drawings, in which:

FIG. 1 is a schematic perspective view illustrating the outer appearance of a magnetic sensor 1 according to an embodiment of the present disclosure;

FIG. 2 is a schematic exploded perspective view of the magnetic sensor 1 from which lower and upper cases 2 and 3 constituting a housing are omitted;

FIG. 3 is a schematic diagram illustrating a first example of an array of sensitivity points P;

FIG. 4 is a schematic diagram illustrating a second example of an array of sensitivity points P;

FIG. 5 is a schematic diagram illustrating a third example of an array of sensitivity points P;

FIG. 6 is a schematic diagram illustrating a fourth example of an array of sensitivity points P;

FIG. 7 is a schematic perspective view of a fixture 100 used for measuring the sensitivity of the magnetic sensor 1;

FIGS. 8A and 8B are schematic diagrams for explaining the positional relationship between the fixture 100 and the magnetic sensor 1;

FIG. 9 is a graph illustrating the relation between the position of the magnetic sensor 1 in the Z-direction and the sensitivity g; and

FIG. 10 is a graph illustrating the relation between the number of the sensitivity points P and the calculated sensitivity g.

DETAILED DESCRIPTION OF THE EMBODIMENTS

Some embodiments of the present disclosure will be explained below in detail with reference to the accompanying drawings.

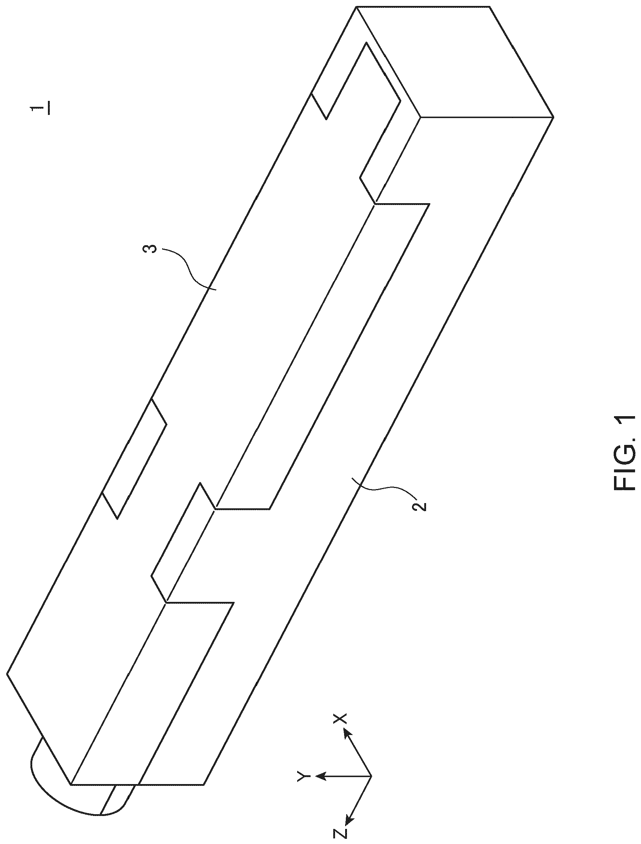

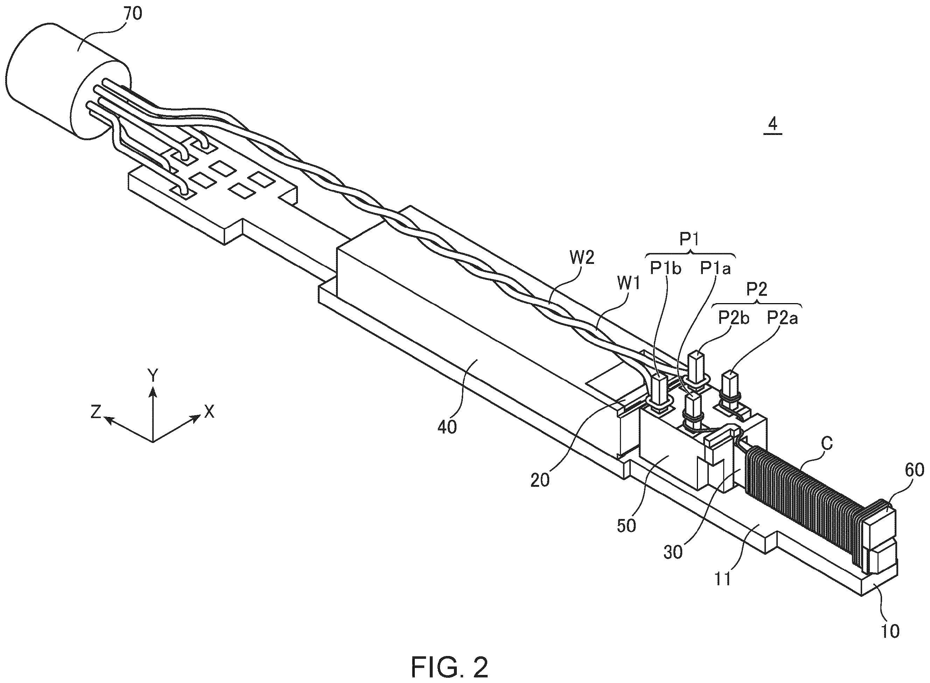

FIG. 1 is a schematic perspective view illustrating the outer appearance of a magnetic sensor 1 according to an embodiment of the present disclosure. FIG. 2 is a schematic exploded perspective view of the magnetic sensor 1 from which lower and upper cases 2 and 3 constituting a housing are omitted.

As illustrated in FIGS. 1 and 2, the magnetic sensor 1 according to the present embodiment has a magnetic sensor module 4 as the main part thereof and lower and upper cases 2 and 3 for accommodating therein the magnetic sensor module 4. The lower and upper cases 2 and 3 are made of, for example, a nonmagnetic insulating material such as resin, and the magnetic sensor module 4 is housed in an internal space formed when the lower and upper cases 2 and 3 are fitted to each other in the Y-direction. The magnetic sensor 1 has a bar-like shape elongated in the Z-direction, and the end portion thereof in the negative Z-direction constitutes a sensor head. On the other hand, from the end portion of the magnetic sensor 1 in the positive Z-direction, a not-shown wire connected to the magnetic sensor module 4 is led out.

The magnetic sensor module 4 has a substrate 10, a sensor chip 20 and magnetism collecting bodies 30 and 40 which are mounted on a surface 11 of the substrate 10 constituting the XZ surface, a compensating coil C wound around the magnetism collecting body 30, and molded members 50 and 60 fixed to the magnetism collecting body 30. The sensor chip 20 has not-shown magnetosensitive elements integrated therein. The magnetosensitive elements are not particularly limited in type so long as they are elements whose electric resistance varies depending on the direction and strength of magnetic flux and may be, for example, an MR element.

The magnetism collecting bodies 30 and 40, which are provided for collecting magnetic flux in the sensor chip 20, each have a bar-like shape elongated in the Z-direction and made of a high permeability material such as ferrite. The sensor chip 20 is disposed between the magnetism collecting bodies 30 and 40, whereby a magnetic field in the Z-direction is selectively collected, and the collected magnetic field is applied to the sensor chip 20.

The compensating coil C is formed of a wire (coated conductive wire) which is wound around the magnetism collecting body 30 so as to make its coil axis extend in the Z-direction. The molded members 50 and 60 are made of a nonmagnetic insulating material such as resin and are fixed to the magnetism collecting body 30 through an adhesive or the like. The molded member 50 covers the vicinity of the end portion of the magnetism collecting body 30 in the positive Z-direction, and the molded member 60 covers the vicinity of the end portion of the magnetism collecting body 30 in the negative Z-direction.

The molded member 50 retains U-shaped pins P1 and P2. One end of the compensating coil C is fixed to one end P1a of the pin P1, and the other end thereof is fixed to one end P2a of the pin P2. The one end and the other end of the compensating coil C are both thus positioned on the molded member 50 side. Therefore, the compensating coil C needs to be wound so as to make a turn in the vicinity of the end portion of the magnetism collecting body 30 in the negative Z-direction, so the molded member 60 is used to assist the turning.

The other end P1b of the pin P1 and the other end P2b of the pin P2 are connected to a connector 70 through respective wires W1 and W2. The connector 70 is connected with a not-shown wire. To the wire connected to the connector 70, a detection signal according to the direction and strength of a magnetic field applied to the magnetic sensor 1 is output.

The magnetic sensor 1 having the above configuration is designed to have a predetermined detection sensitivity to a magnetic field; however, it does not always obtain a designed detection sensitivity due to the individual difference or manufacturing error among elements or manufacturing variation. In the present embodiment, the sensitivity of the magnetic sensor 1 is measured before actual measurement in order to perform more accurate magnetic detection using the magnetic sensor 1. The following describes a method for measuring the sensitivity of the magnetic sensor 1.

In the sensitivity measurement of the magnetic sensor 1, a known magnetic field is actually applied to the magnetic sensor 1, and an output value output from the sensor chip 20 is measured. An output value V of the sensor chip 20 can be represented by the following expression (1).

$$V = g \times n \cdot B \qquad \cdots (1)$$

In the expression (1), g denotes the sensitivity of the magnetic sensor 1, n denotes the sensitivity direction of the magnetic sensor 1, and B denotes a magnetic field vector applied to the magnetic sensor 1. Here, when the strength of a magnetic field to be generated, distance between a magnetic field generation source and the magnetic sensor 1, and sensitivity direction of the magnetic sensor 1 with respect to the magnetic field generation source are known, a sensitivity direction n and a theoretical magnetic field strength B to be applied to the magnetosensitive elements can be calculated, making it possible to calculate an actual sensitivity g by referring to the output value V of the sensor chip 20.

However, the actual magnetic sensor 1 is not a virtual point but a physical device having a predetermined volume, so that when magnetic field distribution in the magnetic sensor 1 is nonuniform, the magnetic field strengths B slightly differ from one another depending on the internal position of the magnetic sensor 1. Therefore, the true sensitivity g of the magnetic sensor 1 cannot be calculated from one sensitivity point defined in the magnetic sensor 1. In the present embodiment, such an error is reduced by defining a plurality of virtual sensitivity points in the magnetic sensor 1.

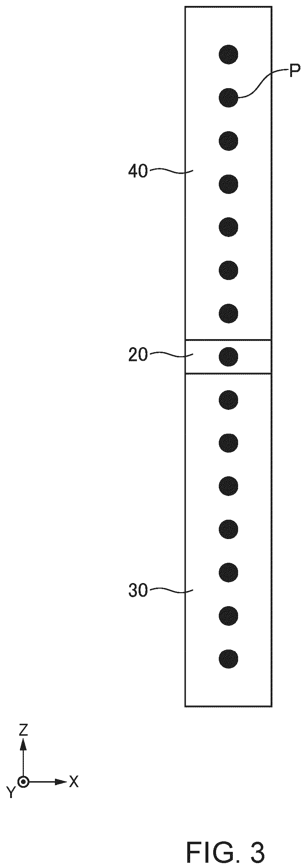

The plurality of virtual sensitivity points defined in the magnetic sensor 1 are evenly distributed inside the housing. For example, as illustrated in FIG. 3, a plurality of sensitivity points P are arranged along the magnetism collecting body 40, sensor chip 20, and magnetism collecting body 30. In the example illustrated in FIG. 3, one sensitivity point P is located on the sensor chip 20, and seven sensitivity points P are located on each of the magnetism collecting bodies 30 and 40. These 15 sensitivity points P are arranged in a line in the Z-direction which is the sensitivity axis direction of the magnetic sensor 1 and at a constant pitch. The positions of the sensitivity points P in the X-direction coincide with the centers of the magnetism collecting body 40, sensor chip 20, and magnetism collecting body 30 in the width direction (X-direction). The positions of the sensitivity points P in the Y-direction may be set on the surfaces of the magnetism collecting body 40, sensor chip 20, and magnetism collecting body 30 or set in the internal positions of the same.

Then, the sensitivity of the magnetic sensor 1 is calculated based on a simple average value of the theoretical magnetic field strengths B at the plurality of sensitivity points P and the output value V of the sensor chip 20. When the sensitivity point P is defined in plural number, the output value V of the sensor chip 20 can be represented by the following expression (2).

$$V = g \frac{1}{N} \sum_{k=1}^{N} B(r_n) \cdot n \qquad \cdots (2)$$

In the expression (2), N denotes the number of the sensitivity points P, and $B(r_n)$ denotes a theoretical magnetic field strength at each of the sensitivity points P. Here, when the strength of a magnetic field to be generated, the distance between a magnetic field generation source and the sensitivity points P, and the direction of each sensitivity point P with respect to the magnetic field generation source are known, it is possible to calculate the actual sensitivity g by simply averaging the theoretical magnetic field strengths B at the respective sensitivity points P.

As described above, in the present embodiment, the simple average value of the theoretical magnetic field strengths B at the plurality of respective virtual sensitivity points P evenly distributed inside the housing of the magnetic sensor 1 is calculated, thus making it possible to easily calculate the sensitivity g of the magnetic sensor 1 based on the actual output value V of the sensor chip 20. In other words, the simple average value of the magnetic field strengths B at the plurality of respective sensitivity points P is calculated without addition of weighting parameters to the sensitivity points P, allowing the sensitivity g of the magnetic sensor 1 to be calculated through relatively simple calculations. That is, when weighting parameters are added respective to a small number of the sensitivity points P, not only a large amount of calculation time is taken, but also there may be a case where a stable solution cannot be obtained; however, in the present embodiment, a large number of the sensitivity points P are set, and the simple average value of the theoretical magnetic field strengths at these sensitivity points P is calculated, whereby the amount of calculations is reduced, and also the calculation accuracy is maintained.

The number of the sensitivity points P can be determined based on the size of each sensitivity area, a magnetic field gradient in the area, and required accuracy, i.e., an allowable error. The more the number of the sensitivity points P is, the more accurately the sensitivity g can be calculated; however, an excessively large number of the sensitivity points P correspondingly complicates calculations. Considering this, the number of the sensitivity points P is practically preferably 10 or more and 100 or less. When the number of the sensitivity points P is 10 or more, it is possible to reduce a required calculation amount while maintaining the calculation accuracy equal to or higher than that in a case where weighting parameters are added to several (e.g., five) sensitivity points P.

The sensitivity points P may not necessarily be set at a position where the magnetism collecting body exists, so long as it is positioned inside the housing of the magnetic sensor 1 or in the vicinity thereof.

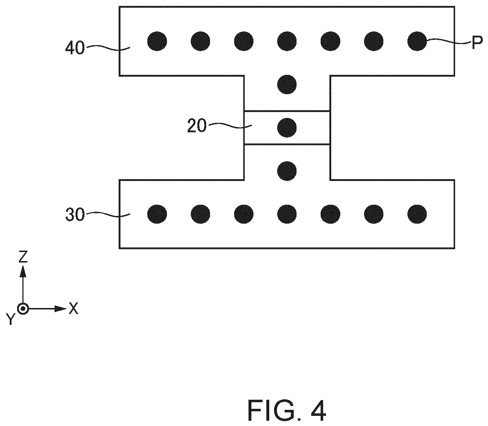

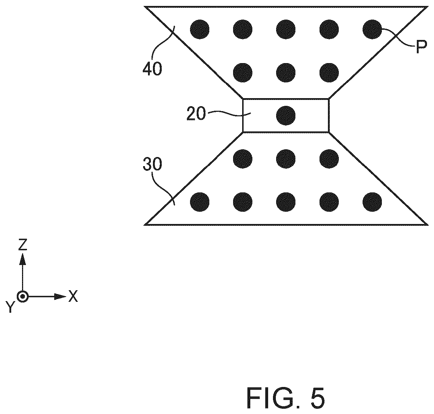

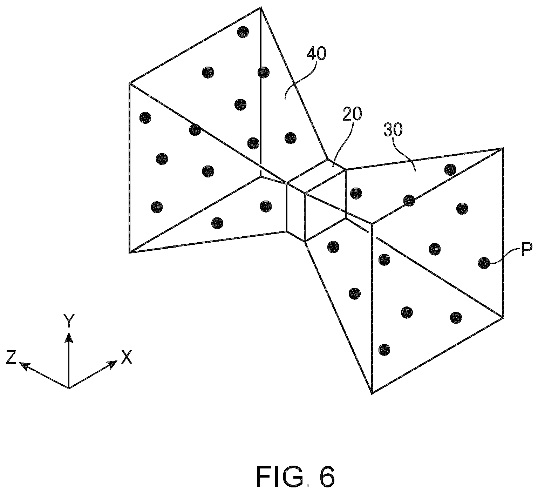

In the example illustrated in FIG. 3, although the plurality of the sensitivity points P are arranged in a line in the Z-direction which is the sensitivity axis direction of the magnetic sensor 1, the arrangement of the sensitivity points P is not limited to this. For example, when the magnetism collecting bodies 30 and 40 constitute a T-like shape as illustrated in FIG. 4, the sensitivity points P may be arranged in the X-direction on the magnetism collecting bodies 30 and 40 and in the Z-direction at a portion where the magnetism collecting bodies 30 and 40 sandwich the sensor chip 20. Further, when the widths of the magnetism collecting bodies 30 and 40 in the X-direction are tapered toward the sensor chip 20 as illustrated in FIG. 5, the arrangement number of the sensitivity points P in the X-direction may be reduced toward the sensor chip 20. Furthermore, as illustrated in FIG. 6, the sensitivity points P may be three-dimensionally distributed inside the magnetism collecting bodies 30 and 40.

As described above, in the present embodiment, the sensitivity g of the magnetic sensor 1 can be calculated more accurately through relatively simple calculations. Thus, using the magnetic sensor 1 whose sensitivity has been calculated through the sensitivity measurement method according to the present embodiment can achieve more accurate magnetism measurement. Further, constituting a magnetic field detection device by arranging the thus configured magnetic sensors 1 in an array allows the spatial position of a magnetic field source to be specified accurately.

While some embodiments of the technology according to the present disclosure have been described, the technology according to the present disclosure is not limited to the above embodiments, and various modifications may be made within the scope of the present disclosure, and all such modifications are included in the technology according to the present disclosure.

The technology according to the present disclosure includes the following configuration examples, but not limited thereto.

A sensitivity measurement method according to an aspect of the present disclosure is a method for measuring the sensitivity of a magnetic sensor provided with a sensor chip having a magnetosensitive element, a magnetism collecting body for collecting a magnetic field to the sensor chip, and a housing for accommodating therein the sensor chip and the magnetism collecting body. The method includes applying a magnetic field to the magnetic sensor and calculating the sensitivity of the magnetic sensor based on a simple average value of theoretical magnetic field strengths at a plurality of virtual sensitivity points evenly distributed inside the housing and an output value output from the senor chip. This makes it possible to calculate the sensitivity of the magnetic sensor with a small amount of calculation.

In the above sensitivity measurement method, the plurality of the sensitivity points may be arranged on the magnetism collecting body and the sensor chip. This makes it possible to calculate the sensitivity of the magnetic sensor more accurately.

In the above sensitivity measurement method, the magnetism collecting body may include first and second magnetism collecting bodies, the sensor chip may be disposed between the first magnetism collecting body and the second magnetism collecting body, and at least one of the plurality of sensitivity points may be arranged on the sensor chip, and the remaining ones of the plurality of sensitivity points may be arranged on the first and second magnetism collecting bodies. This makes it possible to calculate the sensitivity of the magnetic sensor more accurately.

In the above sensitivity measurement method, the number of the sensitivity points may be 10 or more. This makes it possible to calculate the sensitivity of the magnetic sensor more accurately.

A magnetic sensor according to an aspect of the present disclosure is a magnetic sensor whose sensitivity is calculated by the above sensitivity measurement method. A magnetic field source detection device according to an aspect of the present disclosure includes a plurality of the above magnetic sensors.

EXAMPLES

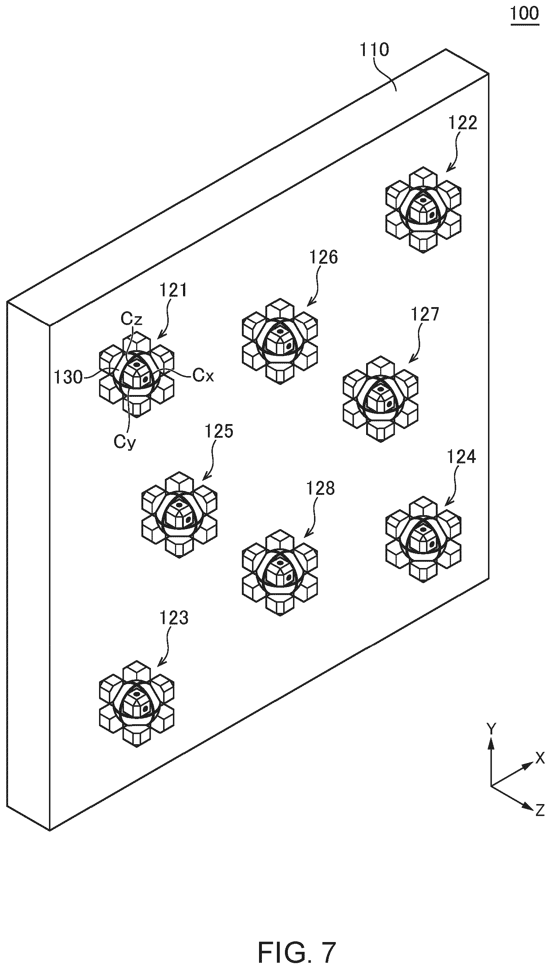

A fixture 100 illustrated in FIG. 7 was used to measure the sensitivity of the magnetic sensor 1. The fixture 100 includes a plate 110 having an XY plane, and eight magnetism generating parts 121 to 128 fixed to the surface of the plate 110. The magnetism generating parts 121 to 128 each include a spherical bobbin 130 and X-, Y-, and Z-axes coils Cx, Cy, and Cz which are wound around the bobbin 130. The X-axis coil Cx is wound such that the coil axis direction thereof is the X-direction, the Y-axis coil Cy is wound such that the coil axis direction thereof is the Y-direction, and the Z-axis coil Cz is wound such that the coil axis direction thereof is the Z-direction. The X-, Y-, and Z-axes coils Cx, Cy, and Cz are independent of one another, and when current is made to flow in these coils Cx, Cy, and Cz, an optional magnetic field can be generated in three-axis directions.

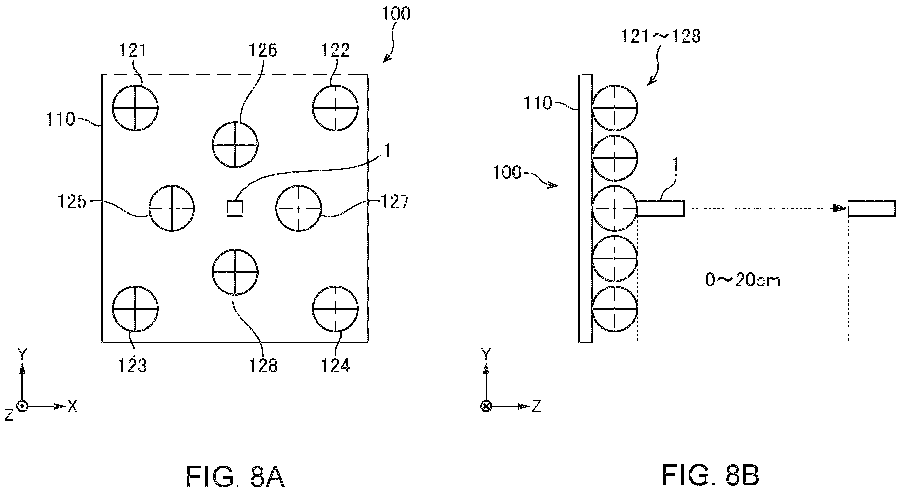

FIG. 8A is an exemplary view for explaining the positions of the magnetism generating parts 121 to 128 on the XY plane. As illustrated in FIG. 8A, the four magnetism generating parts 121 to 124 are disposed near the four corners of the plate 110, and the remaining four magnetism generating parts 125 to 128 are disposed so as to be surrounded by the magnetism generating parts 121 to 124. In the initial state, the magnetic sensor 1 is disposed on the XY plane at the center of an area surrounded by the magnetism generating parts 125 to 128. As illustrated in FIG. 8B, the initial position of the magnetic sensor 1 in the Z-direction coincides with the top positions of the magnetism generating parts 121 to 128 in the Z-direction measured from the surface of the plate 110. The Z-direction position in the initial state is defined as 0 mm.

In this state, current was made to flow through the coils Cx, Cy, and Cz included in each of the magnetism generating parts 121 to 128 one by one, and a magnetic field generated by this was measured by the magnetic sensor 1 to acquire the output value V. This operation was executed for all the coils Cx, Cy, and Cz included in each of the magnetism generating parts 121 to 128, and an inverse problem was solved, by using a least square method, based on magnetic field data obtained by the above operation to determine the output value V at this position. Further, the theoretical magnetic field strengths B at the plurality of sensitivity points P defined in the magnetic sensor 1 were calculated, and the above expression (2) was solved based on the above to calculate the sensitivity g of the magnetic sensor 1.

Then, the magnetic sensor 1 was moved in the positive Z-direction with the position thereof in the XY plane direction fixed, and the above measurement was performed again at the resultant position to acquire the output value V. Further, the theoretical magnetic field strengths B at the plurality of sensitivity points P defined in the magnetic sensor 1 were calculated, and the above expression (2) was solved based on the above to calculate the sensitivity g of the magnetic sensor 1. Since the position of the magnetic sensor 1 in the Z-direction and the sensitivity g of the magnetic sensor 1 are irrelevant to each other, the value of the calculated sensitivity g is ideally constant irrelevant to the position of the magnetic sensor 1 in the Z-direction.

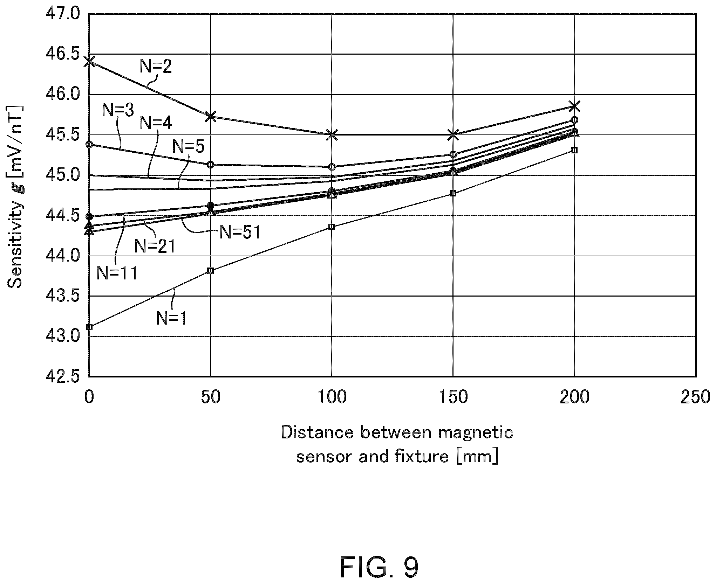

FIG. 9 is a graph illustrating the relation between the position of the magnetic sensor 1 in the Z-direction and the sensitivity g. In the example illustrated in FIG. 9, the actual sensitivity g of the magnetic sensor 1 measured using a Helmholtz coil is 45 mV/nT. As can be seen from FIG. 9, when the number of the sensitivity points P defined in the magnetic sensor 1 was one, the calculated sensitivity g significantly varies depending on the Z-direction position. Further, it can be seen that the variation in the calculated sensitivity g in the Z-direction became smaller as the number of the sensitivity points P defined in the magnetic sensor 1 increased.

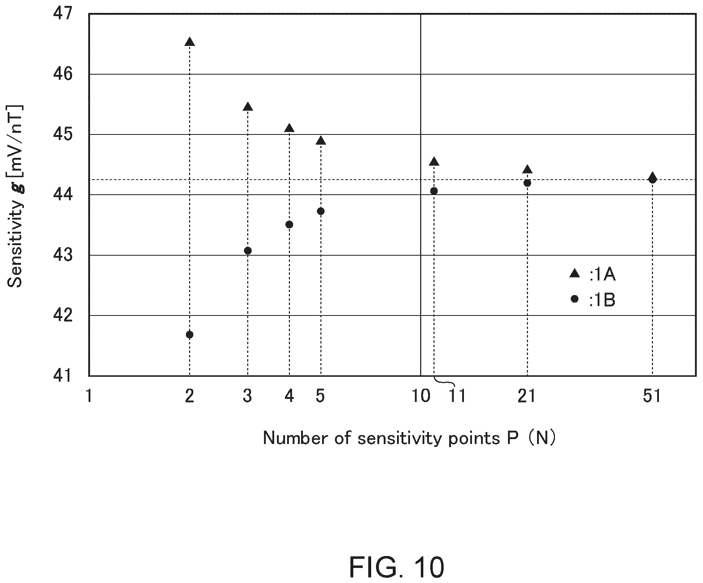

FIG. 10 is a graph illustrating, for each of two magnetic sensors 1A and 1B of different types, the relation between the number of the sensitivity points P and the calculated sensitivity g. The positions of the magnetic sensors 1A and 1B in the Z-direction were fixed to 150 mm. As denoted by the dashed line, the actual sensitivity g of the magnetic sensors 1A and 1B measured using the Helmholtz coil was 44.3 mV/nT. As illustrated in FIG. 10, the larger the number of the sensitivity points P defined in the magnetic sensors 1A and 1B became, the closer the calculated sensitivity g was to the actual value.

Specifically, when the number of the sensitivity points P was less than 10, the calculated sensitivity g deviated from the actual sensitivity by 10% or more, whereas when the number of the sensitivity points P was set to 11, the deviation decreased to less than 10%. Further, when the number of the sensitivity points P was increased to 21, the deviation decreased to less than 5%, and when the number of the sensitivity points P was set to 51, the calculated sensitivity g substantially coincided with the actual value.

When the number of the sensitivity points is set to 11, 1 sensitivity point P is defined on the sensor chip 20, 5 of the remaining 10 sensitivity points P should be defined on the magnetism collecting body 30, and the remaining 5 sensitivity points should be defined on the magnetism collecting body 40. When the number of the sensitivity points is set to 21, 1 sensitivity point P should be defined on the sensor chip 20, 10 of the remaining 20 sensitivity points P should be defined on the magnetism collecting body 30, and the remaining 10 sensitivity points should be defined on the magnetism collecting body 40. When the number of the sensitivity points P is set to 51, 1 sensitivity point P should be defined on the sensor chip 20, 25 of the remaining 50 sensitivity points P should be defined on the magnetism collecting body 30, and the remaining 25 sensitivity points P should be defined on the magnetism collecting body 40.

## Claims

1. A sensitivity measurement method for measuring a sensitivity of a magnetic sensor provided with a sensor chip having a magnetosensitive element, a magnetism collecting body for collecting a magnetic field to the sensor chip, and a housing for accommodating therein the sensor chip and the magnetism collecting body, the method comprising:

   applying a magnetic field to the magnetic sensor; and
   calculating the sensitivity of the magnetic sensor based on a simple average value of theoretical magnetic field strengths at a plurality of virtual sensitivity points evenly distributed inside the housing and an output value output from the senor chip.

2. The sensitivity measurement method as claimed in claim 1, wherein the plurality of the sensitivity points are arranged on the magnetism collecting body and the sensor chip.

3. The sensitivity measurement method as claimed in claim 2,

   wherein the magnetism collecting body includes first and second magnetism collecting bodies,
   wherein the sensor chip is disposed between the first magnetism collecting body and the second magnetism collecting body,
   wherein at least one of the plurality of sensitivity points is arranged on the sensor chip, and
   wherein remaining ones of the plurality of sensitivity points are arranged on the first and second magnetism collecting bodies.

4. The sensitivity measurement method as claimed in claim 3, wherein a number of the sensitivity points are 10 or more.

5. A magnetic sensor comprising:

   a sensor chip having a magnetosensitive element;
   a magnetism collecting body for collecting a magnetic field to the sensor chip; and
   a housing for accommodating therein the sensor chip and the magnetism collecting body,
   wherein a sensitivity of the magnetic sensor is measured by applying a magnetic field to the magnetic sensor, and calculating the sensitivity of the magnetic sensor based on a simple average value of theoretical magnetic field strengths at a plurality of virtual sensitivity points evenly distributed inside the housing and an output value output from the senor chip.

FIG. 1

FIG. 2

EP 4 664 135 A2

FIG. 3

FIG. 4

FIG. 5

FIG. 6

FIG. 7

FIG. 8B

FIG. 8A

FIG. 9

FIG. 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **ADACHI, Y. et al.** Evaluation of Directional Dependence of Sensitivity for Room-Temperature Magnetic Flux Sensors with Wide Sensitivity Region. *IEEE transactions on Magnetics*, 2021, vol. 57 (2), 4000105